**Europäisches Patentamt**

**European Patent Office**

**Office européen des brevets**

(19)

(11) Veröffentlichungsnummer: **0 045 046 B1**

(12) **EUROPÄISCHE PATENTSCHRIFT**

(45) Veröffentlichungstag der Patentschrift:
24.10.84

(21) Anmeldenummer: **81105754.6**

(22) Anmeldetag: **21.07.81**

(51) Int. Cl.³: **H 01 L 27/08, H 01 L 21/268, G 11 C 11/40**

(54) Halbleiterbauelement und seine Verwendung für statische 6-Transistorzelle.

(30) Priorität: **24.07.80 DE 3028111**

(43) Veröffentlichungstag der Anmeldung:
**03.02.82 Patentblatt 82/5**

(45) Bekanntmachung des Hinweises auf die Patenterteilung:
**24.10.84 Patentblatt 84/43**

(84) Benannte Vertragsstaaten:
**FR GB**

(56) Entgegenhaltungen:
**DE - A - 2 503 864**
**US - A - 3 585 088**

(73) Patentinhaber: **Siemens Aktiengesellschaft, Berlin und München Wittelsbacherplatz 2, D-8000 München 2 (DE)**

(72) Erfinder: **Runge, Hartmut, Dr. Dipl.-Phys., Antwerpenerstrasse 1, D-8000 München 40 (DE)**

## Beschreibung

Die Erfindung bezieht sich auf ein Halbleiterbauelement mit mindestens zwei Isolierschicht-Feldeffekttransistoren gemäss dem ersten Teil des Patentanspruchs 1.

Ein solches Halbleiterbauelement ist aus der DE-OS 25 03 864 bekannt. Bei diesem Bauelement werden die Dotierungsbereiche in einem Halbleiterkörper für den Aufbau der einzelnen Isolierschicht-Feldeffekttransistoren mehrfach ausgenutzt, wobei eine Halbleiterfläche für die Ausgestaltung mit zwei Isolierschicht-Feldeffekttransistoren beansprucht wird, die um die auf ein Source- oder Draingebiet des Transistors fallende Teilfläche kleiner ist als bei einem Aufbau von zwei unabhängig voneinander aufgebauten Isolierschicht-Feldeffekttransistoren.

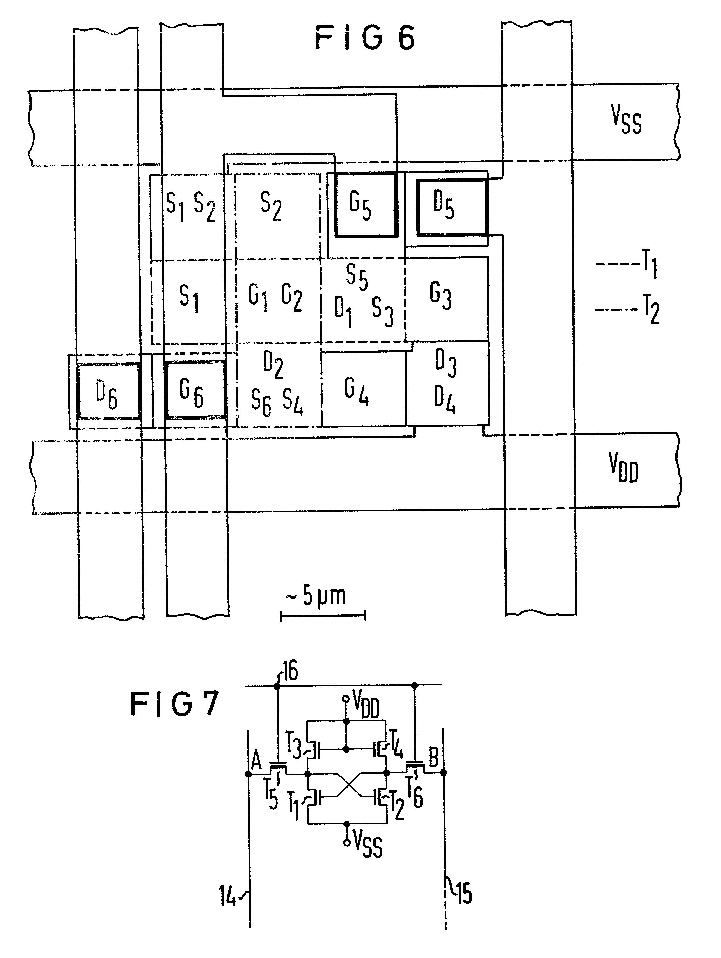

Der Erfindung liegt die Aufgabe zugrunde, dieses Prinzip des verringerten Platzbedarfes für hochintegrierte, statische Halbleiterspeicher, insbesondere für die Schalttransistoren einer 6-Transistorzelle zu verwenden. Eine solche statische 6-Transistorzelle ist beispielsweise aus dem Buch «Semiconductor Memory Design and Application» von Luecke, Mize, Carr, Mac Graw-Hill, Kogakusha, Ltd., Figur 5.3, S. 118 zu entnehmen.

Trotz der vielen Vorteile, die eine statische Speicherzelle bietet, hat sich bislang aus Flächenbedarfsgründen – die 6-Transistorzelle benötigt ca. 2000 bis 2500 $\mu m^2$ in der 5 $\mu m$-Technologie – die flächengünstigere 1-Transistorzelle durchgesetzt, die jedoch dynamisch betrieben werden muss.

Zur Lösung der Aufgabe, mit verringertem Platzbedarf eine statische 6-Transistorzelle zu realisieren, wird ein Halbleiterbauelement der eingangs genannten Art vorgeschlagen, welches gegenüber dem Stand der Technik dadurch gekennzeichnet ist, dass das aus Polysilizium bestehende Gate des ersten Isolierschicht-Feldeffekttransistors durch bereichsweise Umwandlung von Polysilizium in die einkristalline Struktur zugleich einkristalline Gebiete des zweiten Transistors bildet. Dabei liegt es im Rahmen der Erfindung, dass auf der durch bereichsweise Umwandlung von Polysilizium erzeugten einkristallinen Siliziumschicht mehrere Doppelschichten, jeweils bestehend aus einer weiteren isolierenden Schicht und einer weiteren, diese bedeckende Schicht aus bereichsweise umgewandelten Polysilizium in die einkristalline Struktur, aufgebracht sind und dass in jeder der weiteren Schichten aus bereichsweise umgewandelten einkristallinem Silizium ein Bereich vorgesehen ist, der das Source- und/oder das Draingebiet eines weiteren Isolierschicht-Feldeffekttransistors bildet, dessen Gate, Drain- und/oder Sourcebereich sich in anderen Schichten aus bereichsweise umgewandelten einkristallinen Silizium befindet.

In einer Weiterbildung des Erfindungsgedankens ist vorgesehen, dass das einkristalline Siliziumgebiet durch Laser- oder Elektronenbestrahlung erzeugt ist. Wie aus E.F. Krimmel, Semiconductor Device University Bulletin Meeting, C.N.R. – LAMEL, Bologna, 15.6.1979 und A.F. Tasch jun., T.C. Holloway, K.F. Lee, J.F. Gibbons, «Electronics Letters 15, 435–437, (1979) bekannt ist, ist es möglich, mit Hilfe der Laser- oder Elektronenstrahlausheilung auf amorphem $SiO_2$ aufgebrachtes polykristallines Silizium bereichsweise einkristallin zu machen und in diesen Bereichen funktionsfähige Transistoren herzustellen. Hierdurch ergibt sich die Möglichkeit, die Schalttransistoren der 6-Transistorzelle in bisher nicht bekannter Weise zu kombinieren und dadurch wesentlich an Silizium-Oberfläche einzusparen.

Besonders vorteilhafte Weiterbildungen der Erfindung ergeben sich aus den Unteransprüchen, sowie aus den in der Zeichnung befindlichen Figuren 1 bis 7. Dabei zeigen

die Figuren 1 bis 3 die Anordnung der Isolierschicht-Feldeffekttransistoren im Halbleiterkörper in T-Struktur-Gate-Stapelform (Gate-Stack), wobei die Figur 3 ein vollständiges Layout einer 6-Transistorzelle zeigt, während

die Figuren 4 bis 6 ein analoges Ausführungsbeispiel in Kreuz-Struktur-Gate-Stapelform (Gate-Stack) darstellen.

Mit $S_1$, $S_2$, $S_3$, $S_4$, $S_5$ und $S_6$ sind die Sourcebereiche, mit $D_1$, $D_2$, $D_3$, $D_4$, $D_5$ und $D_6$ die Drainbereiche und mit $G_1$, $G_2$, $G_3$, $G_4$, $G_5$ und $G_6$ die Gatebereiche gekennzeichnet. Mit 10 ist die den Halbleiterkörper 11 bedeckende, aus $SiO_2$ bestehende erste Isolierschicht, mit 12 die zweite Isolierschicht bezeichnet. In Figur 7 ist ein Schaltbild einer 6-Transistor-RAM-Zelle angegeben, die mit dem nach der Erfindung aufgebauten Halbleiterbauelement leicht realisiert werden kann. Dabei sind mit $V_{DD}$ die Betriebsspannung und $V_{SS}$ der Betriebsspannungsnullpunkt, mit 14 und 15 die Bitleitung A und B und mit 16 die Wortleitung gekennzeichnet.

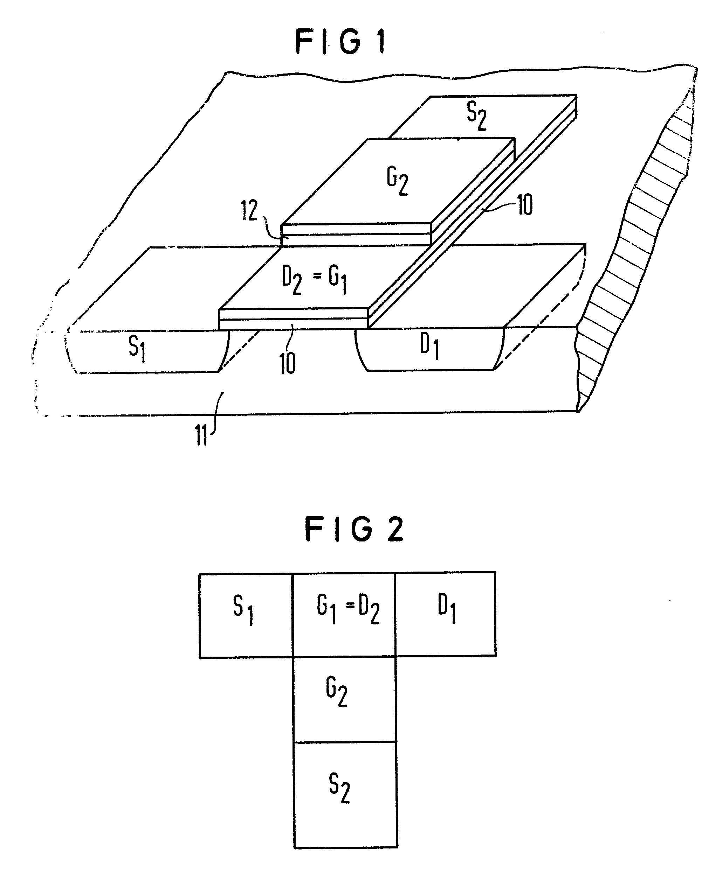

Figur 1 und 2: Der Transistor 1 wird in bekannter Weise hergestellt. Das polykristalline Siliziumgate $G_1$ dieses Transistors ($S_1 D_1 G_1$) setzt sich jedoch in lateraler Richtung fort und wird erfindungsgemäss durch Laser- oder Elektronenstrahlausheilung einkristallin gemacht und auf diesem Gebiet ein zweiter Transistor ($D_2 G_2 S_2$) hergestellt, wobei das Drain $D_2$ von Transistor 2 gleichzeitig als Gate $G_1$ von Transistor 1 dient.

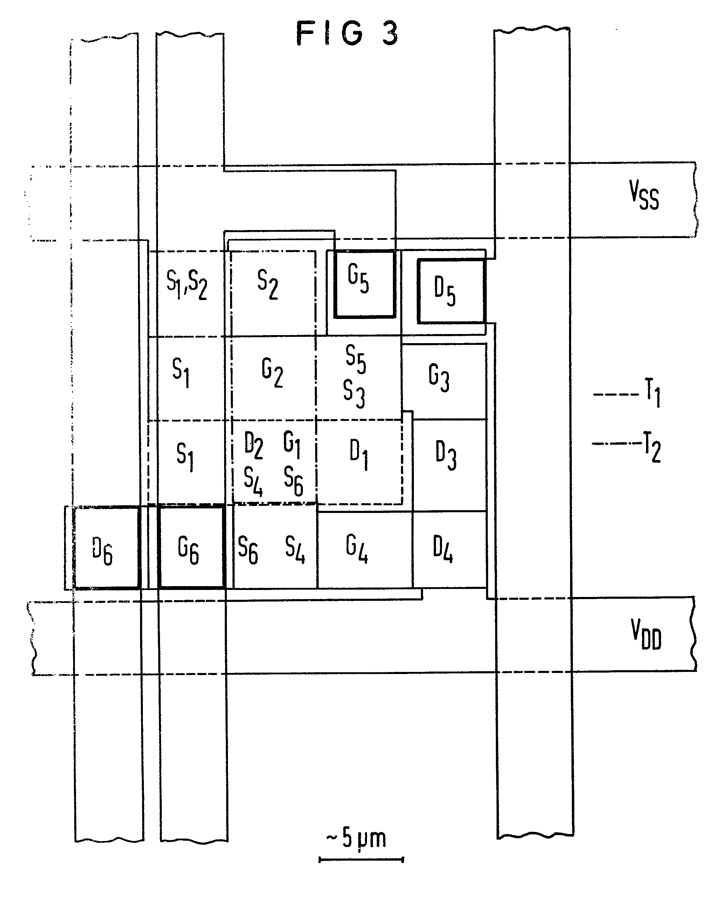

Die Weiterbildung ist aus Figur 3 ersichtlich. Die Fläche beträgt $25 \times 25 = 625$ $\mu m^2$. Die gestrichelte Linie umschreibt den Transistor 1, die strichpunktierte den Transistor 2.

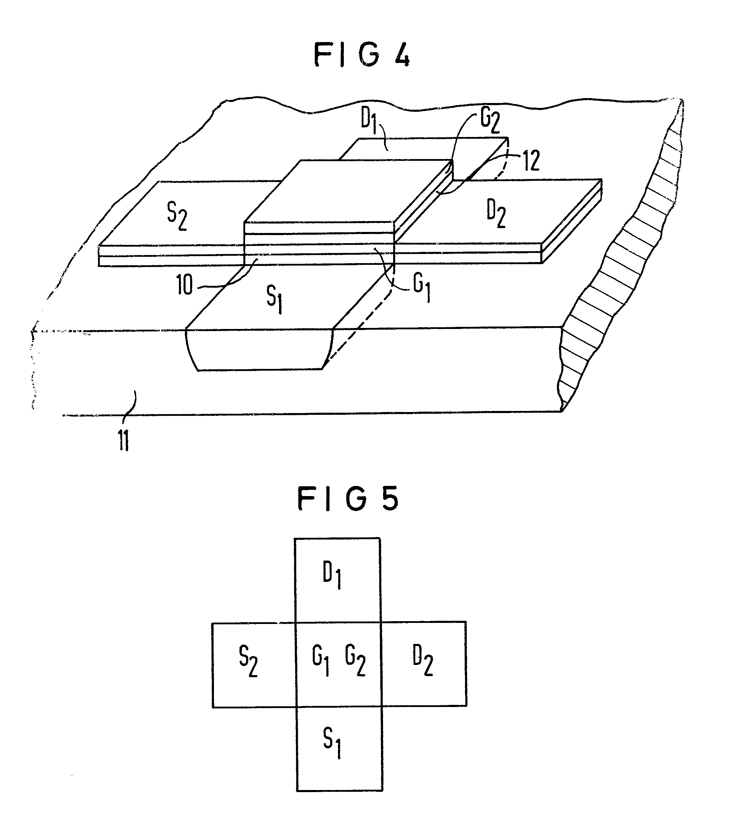

Figur 4 und 5: Eine weitere Platzersparnis ergibt sich, wenn die beiden Schalttransistoren kreuzförmig übereinandergelegt werden. Dabei ist, wie aus Figur 4 und 5 ersichtlich, die laterale Ausdehnung des Gates $G_1$ des Transistors 1 das Drain $D_2$- und das Source $S_2$-Gebiet vom Transistor 2. Hierbei ist der stromführende Transistor in den Bereichen leitend, in denen das Potential des gesperrten Transistors über der Einsatzspannung liegt. Soll ein vollständiges Durchschalten des stromführenden Transistors erreicht werden, so muss ein Dotierungsgradient der Transistoren von Source nach Drain hergestellt werden, was beispielsweise durch Ionenimplantation durch

3 0 045 046 4

ein abgeschrägtes Oxid als Implantationsmaske erfolgen kann.

Die Weiterbildung von Figur 4 und 5 ist aus dem in Figur 6 dargestellten Layout in analoger Weise wie in Figur 3 ersichtlich. Die Fläche beträgt $20 \times 25 \ \mu m^2$ entspricht $500 \ \mu m^2$. Im übrigen gelten die gleichen Bezugszeichen wie in Figur 3.

## Patentansprüche

1. Halbleiterbauelement mit mindestens zwei Isolierschicht-Feldeffekttransistoren, bei dem in einem von einer elektrisch isolierenden Schicht bedeckten, dotierten Halbleiterkörper das Source- und Draingebiet eines ersten Isolierschicht-Feldeffekttransistors angeordnet ist, bei dem in einer auf der Isolierschicht befindender Siliziumschicht das Source- oder Draingebiet des zweiten Isolierschicht-Feldeffekttransistors derart angeordnet ist, dass die Gateelektrode dieses ersten Feldeffekttransistors auf der isolierenden Schicht zugleich ein Gebiet des anderen Feldeffekttransistors bildet, dadurch gekennzeichnet, dass die Siliziumschicht innerhalb des Bereiches des zweiten Isolierschicht-Feldeffekttransistors durch bereichsweise Umwandlung von Polysilizium in die einkristalline Struktur gebildet wird.

2. Halbleiterbauelement nach Anspruch 1, dadurch gekennzeichnet, dass auf der durch bereichsweise Umwandlung von Polysilizium erzeugten einkristallinen Siliziumschicht mehrere Doppelschichten, jeweils bestehend aus einer weiteren isolierenden Schicht und einer weiteren, diese bedeckende Schicht aus bereichsweise umgewandeltem Polysilizium in die einkristalline Struktur, aufgebracht sind und dass in jeder der weiteren Schichten aus bereichsweise umgewandelten, einkristallinen Silizium ein Bereich vorgesehen ist, der das Source- und/oder das Draingebiet eines weiteren Isolierschicht-Feldeffekttransistors bildet, dessen Gate, Drain- und/oder Sourcebereich sich in anderen Schichten aus bereichsweise umgewandelten einkristallinen Silizium befindet.

3. Halbleiterbauelement nach Anspruch 1 und 2, dadurch gekennzeichnet, dass das einkristalline Siliziumgebiet durch Laser- oder Elektronenbestrahlung erzeugt ist.

4. Halbleiterbauelement nach Anspruch 1 bis 3, dadurch gekennzeichnet, dass die Isolierschicht-Feldeffekttransistorstrukturen so angeordnet sind, dass sie in lateraler Richtung eine T-Struktur-Gate-Stapelform bilden.

5. Halbleiterbauelement nach Anspruch 1 bis 3, dadurch gekennzeichnet, dass die Isolierschicht-Feldeffekttransistorstrukturen so angeordnet sind, dass sie in lateraler Richtung eine Kreuz-Struktur-Gate-Stapelform bilden.

6. Halbleiterbauelement nach Anspruch 1 bis 5, gekennzeichnet durch die Verwendung als Schalttransistoren einer statischen 6-Transistorspeicherzelle.

## Revendications

1. Dispositif à semiconducteurs comportant deux transistors à effet de champ à couche isolante, dans lequel les régions de source et de drain du premier transistor à effet de champ à couche isolante sont disposées dans un corps semiconducteur dopé recouvert par une couche électriquement isolante, et dans lequel la région de source et de drain du second transistor à effet de champ à couche isolante est disposée dans une couche de silicium située sur la couche isolante de telle sorte que l'électrode de grille du premier transistor à effet de champ forme simultanément sur la couche isolante une région de l'autre transistor à effet de champ, caractérisé par le fait que la couche de silicium à l'intérieur de la région du second transistor à effet de champ à couche isolante est formée par transformation, par endroits, du polysilicium lui faisant prendre la structure monocristalline.

2. Dispositif à semiconducteur selon la revendication 1, caractérisé par le fait que plusieurs couches doubles, constituées respectivement par une autre couche isolante et par une autre couche recouvrant cette dernière et constituée par du polysilicium transformé par endroits de manière à posséder la structure monocristalline, sont déposées sur la couche de silicium polycristallin produite par transformation du polysilicium par endroits et que dans chacune des autres couches formées par du silicium monocristalin, transformé par endroits, il est prévu une région qui forme la région de source et/ou la région de drain d'un autre transistor à effet de champ à couche isolante, dont la grille, la région de drain et/ou la région de source sont situées dans d'autres couches formées par du silicium monocristallin, transformé par endroits.

3. Dispositif à semiconducteurs suivant les revendications 1 et 2, caractérisé par le fait que la région de silicium monocristallin est produite par une irradiation avec un faisceau laser ou avec un faisceau électronique.

4. Dispositif à semiconducteurs suivant les revendications 1 à 3, caractérisé par le fait que les structures du transistor à effet de champ à couche isolante sont disposées de manière à réaliser, suivant la direction latérale, un ensemble empilé de grilles à structure en T.

5. Dispositif à semiconducteurs suivant les revendications 1 à 3, caractérisé par le fait que les structures du transistor à effet de champ à couche isolante sont disposées de manière à réaliser, suivant la direction latérale, un ensemble empilé de grilles à structure en forme de croix.

6. Dispositif à semiconducteurs suivant les revendications 1 à 5, caractérisé par son utilisation pour des transistors de commutation d'une cellule de mémoire statique à 6 transistors.

## Claims

1. A semiconductor component having at least two insulating layer field-effect transistors, in which the source and drain zones of a first insulating layer field-effect transistor are arranged in a doped semiconductor body covered with an insulating layer, in which the source or drain zone of the second insulating layer field-effect transistor is arranged in a silicon layer on the insulating layer in such a way that the gate electrode of the first field-effect transistor simultanously forms a zone of the other field-effect transistor on the insulating layer, characterised in that the silicon layer inside the region of the second insulating layer field-effect transistor, is formed by local conversion of polysilicon into the monocrystalline structure.

2. A semiconductor component according to Claim 1, characterised in that on the monocrystalline silicon layer, produced by local conversion of polysilicon, there are provided a plurality of double layers, each consisting of a further insulating layer and a further layer which covers the latter and consists of polysilicon locally-converted into the monocrystalline structure; and that, in each of the further layers, which consists of locally-converted monocrystalline silicon, there is arranged a region which forms the source and/or drain zone of a further insulating layer field-effect transistor, the gate, drain and/or source zone of which are present in other layers consisting of locally-converted monocrystalline silicon.

3. A semiconductor component according to Claim 1 and 2, characterised in that the monocrystalline silicon region is produced by laser or electron radiation.

4. A semiconductor component according to Claim 1 to 3, characterised in that the insulating layer field-effect transistor structures are so arranged that they form a T-structure-gate-stack in the lateral direction.

5. A semiconductor component according to Claim 1 to 3 , characterised in that the insulating layer field-effect transistor structures are so arranged that they form a cross-structure-gate-stack in the lateral direction.

6. A semiconductor component according to Claim 1 to 5, characterised by the use as the switching transistors of a static 6-transistor storage cell.

## FIG 1

## FIG 2

| $S_1$ | $G_1 = D_2$ | $D_1$ |
|-------|-------------|-------|
|       | $G_2$       |       |
|       | $S_2$       |       |

# FIG 3

$V_{SS}$

| $S_1, S_2$ | $S_2$ | $G_5$ | $D_5$ |

| $S_1$ | $G_2$ | $S_5$ $S_3$ | $G_3$ |

- - - $T_1$

- · - · $T_2$

| $S_1$ | $D_2$ $G_1$ $S_4$ $S_6$ | $D_1$ | $D_3$ |

| $D_6$ | $G_6$ | $S_6$ $S_4$ | $G_4$ | $D_4$ |

$V_{DD}$

~5 µm

## FIG 4

## FIG 5

# FIG 6

~5 µm

# FIG 7